# FASCICULE DE BREVET EUROPEEN

(11) **EP 2 070 399 B1**
(45) Date de publication et mention de la délivrance du brevet: **11.01.2017**
(21) Numéro de dépôt: 07858685.6
(22) Date de dépôt: 13.11.2007
(51) Int. Cl.: H05K 1/02, H05K 3/34

(54) **SUBSTRAT IMPRIME PERMETTANT LE PASSAGE DE TRES FORTS COURANTS ET PROCEDE DE REALISATION CORRESPONDANT**
LEITERPLATTE FÜR HOCHSTRÖME UND ENTSPRECHENDES VERFAHREN ZUR HERSTELLUNG
PRINTED CIRCUIT BOARD FOR HIGH CURRENTS AND PRODUCTION METHOD THEREFOR

(30) Priorité: 14.11.2006 FR 0654887
(43) Date de publication de la demande: 17.06.2009
(73) Titulaire: AEG Power Solutions B.V., 1161 AH Zwanenburg (NL)
(72) Inventeur: DELAY, Christian, 37250 Montbazon (FR)
(74) Mandataire: Graefe, Jörg
(86) Numéro de dépôt international: PCT/FR2007/052326
(87) Numéro de publication internationale: WO 2008/059162

(56) Documents cités:
- DE-A1- 4 425 803
- JP-A- 9 153 664
- JP-A- 10 200 221

## Description

### Domaine de l'invention

La présente invention se rapporte au domaine du montage sur substrat ou circuit imprimé des composants de puissance et elle concerne plus particulièrement une architecture permettant le passage de courants de forte puissance, typiquement de l'ordre de 500 ampères ou plus.

### Art antérieur

Aujourd'hui, lorsque l'on souhaite faire passer de forts courants sur un substrat ou un circuit imprimé, il est connu d'augmenter la dimension des pistes conductrices. Si l'on augmente la largeur des pistes, jusqu'à 40 mm par exemple au lieu des 3 mm standard, cela revient particulièrement cher car l'essentiel de la surface du substrat ou du circuit imprimé est alors utilisée uniquement pour les pistes. Aussi, il est souvent préférable d'augmenter plutôt l'épaisseur de ces pistes. Ainsi, alors que la technologie standard qui fait appel à une épaisseur de cuivre de 35 µm autorise des courants maximum de 10 ampères pour une largeur de piste de 3 mm, avec une épaisseur de 140 µm et des largeurs de pistes de 3 mm, il est possible d'atteindre des courants de 25 ampères et de 100 ampères avec des largeurs de pistes de 25 mm. On connait aussi avec la demande DE 4425803 la possibilité d'augmenter encore l'épaisseur de piste en soudant sur celle-ci une bande de métal pouvant atteindre 0,5mm d'épaisseur.

Il est connu aussi que l'utilisation d'une épaisseur de cuivre de 210 µm associée à une technologie multicouches complexe permet d'atteindre des courants de 250 ampères au prix toutefois d'un coût considérable en ce cas.

Une autre technique pour passer des forts courants est de faire appel à une solution entièrement câblée. Toutefois, cette solution est également très onéreuse et sujette à de fréquentes erreurs de câblage. En outre, elle est peu adaptée aux modules enfichables.

### Objet et définition de l'invention

La présente invention a donc pour objet de pallier les inconvénients précités en proposant une nouvelle architecture de circuit imprimé qui permet de passer de très forts courants à structure de circuit imprimé équivalent. Un but de l'invention est aussi de réaliser cette architecture avec les procédés d'assemblage des substrats ou des circuits imprimés conventionnels.

Ces buts sont atteints par un substrat imprimé selon la revendication 1.

Ainsi, les forts courants au lieu de passer dans une simple piste conductrice de puissance passent maintenant dans une sorte de « rail » de puissance, ce qui permet de passer des courants dont le niveau est seulement limité par la section des barreaux conducteurs formant ce rail.

Lesdites parties des barreaux conducteurs reliés entre elles lors dudit processus de soudage sont les extrémités latérales ou les bords longitudinaux desdits barreaux conducteurs.

De préférence, lesdits barreaux conducteurs sont maintenus sur ledit substrat par des points de colle.

Avantageusement, ledit processus de soudage est celui consistant à souder lesdits composants électroniques sur ledit substrat imprimé.

De préférence, lesdits barreaux conducteurs sont des barreaux métalliques de préférence en cuivre ou en aluminium et qui peuvent être avantageusement recouverts d'une protection en alliage de nickel. Chacun desdits barreaux conducteurs a une section déterminée par le niveau de courant à passer.

Lesdites surfaces conductrices de liaison peuvent être reliées entre elles pour former une surface conductrice continue. Ladite surface conductrice continue comporte alors avantageusement des zones d'épargne pour y déposer des points de colle. Dans cette configuration, la surface conductrice peut éventuellement conduire elle aussi une partie du courant, mais sa contribution éventuelle reste faible en regard à la contribution des barreaux conducteurs.
les dimensions desdites surfaces conductrices de liaison sont adaptées pour que, lors du passage dans un four à refusion, une pâte à souder déposée sur une zone, pouvant être déportée, d'une surface conductrice de liaison vienne remplir exactement l'espace entre les deux barreaux conducteurs adjacents reposant sur cette surface conductrice de liaison.

L'invention concerne également un procédé de réalisation d'un substrat imprimé selon la revendication 11. De préférence, lesdites surfaces conductrices de liaison sont des surfaces de cuivre ou de nickel.

Selon le mode de réalisation envisagé, ledit processus de soudage consiste à souder des composants électroniques sur ledit substrat imprimé au moyen d'une soudure à la vague ou dans un four à refusion.

### Brève description des dessins

Les caractéristiques et avantages de la présente invention ressortiront mieux de la description suivante, faite à titre indicatif et non limitatif, en regard des dessins annexés sur lesquels :
- les figures 1 à 3 illustrent trois étapes successives de fabrication d'une plaque de substrat ou de circuit imprimé,
- les figures 4 à 7 illustrent quatre étapes successives de fabrication d'une plaque de substrat ou de circuit imprimé selon un mode de réalisation de l'invention, et
- la figure 8 montre une plaque de circuit imprimé de l'art antérieur.

### Description détaillée de modes de réalisation préférentiels

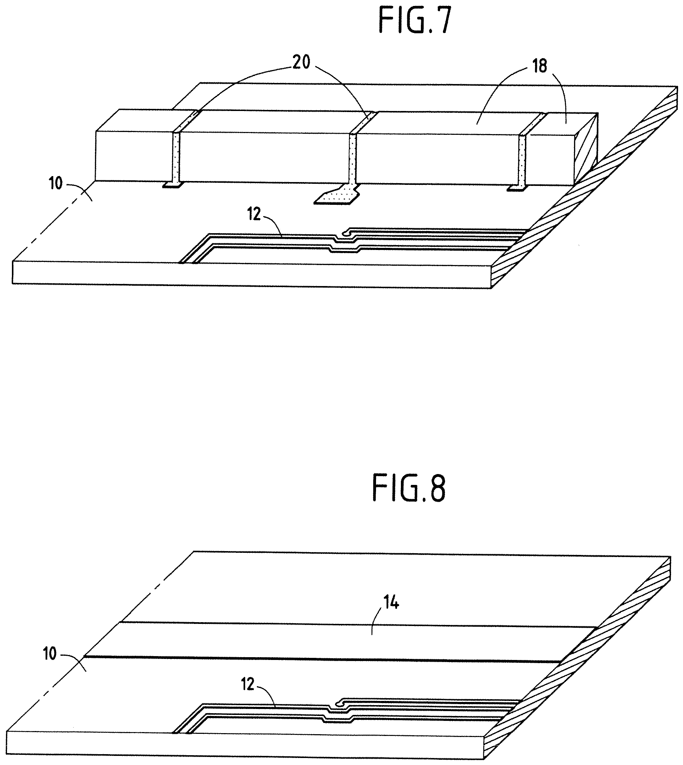

La figure 8 montre un détail d'une architecture conventionnelle de substrat imprimé tel une plaque de circuit imprimé comportant, montées sur une face supérieure d'un substrat ou d'une plaque 10 de circuit isolant, des conducteurs ou pistes conductrices 12 et une piste de puissance 14. Dans une configuration standard, l'épaisseur de la couche de cuivre formant les pistes est de 35 µm et la largeur de la piste de puissance est de 3 mm par exemple.

Comme il est bien connu, ces différentes pistes servent à relier entre eux différents composants électroniques (non illustrés) qui seront montés sur le substrat imprimé, le contact électrique étant assuré par des moyens de fixation à chaud (non illustrés) déposés sur des points dits de soudure lors d'un passage dans un four à refusion ou sur toutes les zones conductrices accessibles lors d'un processus de soudure à la vague.

L'invention propose, sans modification du processus actuel de montage et soudage des cartes électroniques, une structure de substrat imprimé selon la revendication 1 qui, pour une épaisseur de cuivre donnée, permette le passage de courants qu'il est impossible aujourd'hui de faire passer avec une telle épaisseur de cuivre. Notamment, il est proposé une structure de substrat imprimé réalisée lors d'un processus de soudage classique à la vague ou dans un four à refusion qui, avec une épaisseur de cuivre standard de 35 µm et une largeur des pistes de puissance de 3 mm, permette le passage de courants de 500 ampères et au delà.

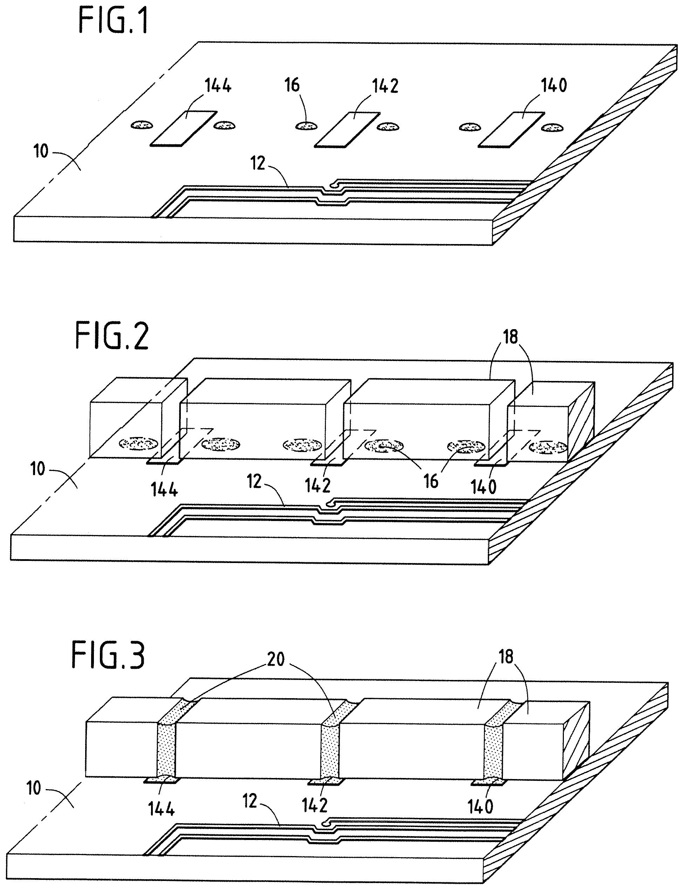

Pour cela, comme l'illustre l'exemple des figures 1 à 3 qui s'applique plus particulièrement au processus de soudage à la vague, la piste de puissance est remplacée par une pluralité de surfaces conductrices de liaison 140, 142, 144 avantageusement en cuivre, mais des surfaces de nickel sont aussi envisageables, espacées régulièrement et entre lesquelles sont déposés des points de colle 16 pour fixer sur le substrat plusieurs barreaux conducteurs 18, les extrémités se faisant face de deux barreaux conducteurs adjacents reposant sur une surface de liaison commune. Ces barreaux conducteurs, de préférence métalliques, par exemple constitués de cuivre ou d'aluminium pouvant être avantageusement recouvert d'une protection en alliage de Nickel, comme un Nickel sulfamat ou un Nickel/Argent, peuvent par exemple présenter chacun une longueur de 10 mm (sans que cette dimension ne soit limitative), une hauteur variable par exemple de 1 à 5 mm (selon le niveau de courant à passer) et une largeur variable, par exemple 3 mm, du même ordre de grandeur que la largeur des surfaces de liaison en cuivre entres lesquelles sont fixés ces barreaux. La figure 2 illustre un exemple de placement des barreaux les uns derrière les autres en laissant entre leurs extrémités latérales un espace d'une largeur de l'ordre de 0,4 mm inférieure à celle de la surface de liaison mais de dimensions suffisantes pour créer lors du processus de soudage à la vague un pont de soudure 20 qui va assurer un joint conducteur entre deux barreaux adjacents (figure 3). Cette soudure sera effectuée de préférence avec la vague réalisant les soudures de l'ensemble des autres composants montés sur le substrat imprimé. Mais, il est aussi envisageable que cette soudure fasse l'objet d'une première vague distincte de celle assurant la fixation des composants.

A l'issue de ce processus de soudage, il est obtenu non plus une piste de puissance mais un « rail » de puissance qui va alors permettre le passage de très forts courants, par exemple 100 ampères avec des barreaux de dimensions 10 mm*5 mm*3 mm, le courant ne passant plus directement par la piste de puissance mais au travers des barreaux conducteurs reliés par les joints de soudure et dont la section détermine alors la quantité de courant admissible.

Il peut être noté que lorsque le rail fait un angle droit (configuration non représentée), le contact entre deux barreaux conducteurs adjacents disposés l'un à la suite de l'autre ne se fera plus par leurs deux extrémités latérales mais par exemple entre une extrémité latérale du premier barreau et un bord longitudinal du second.

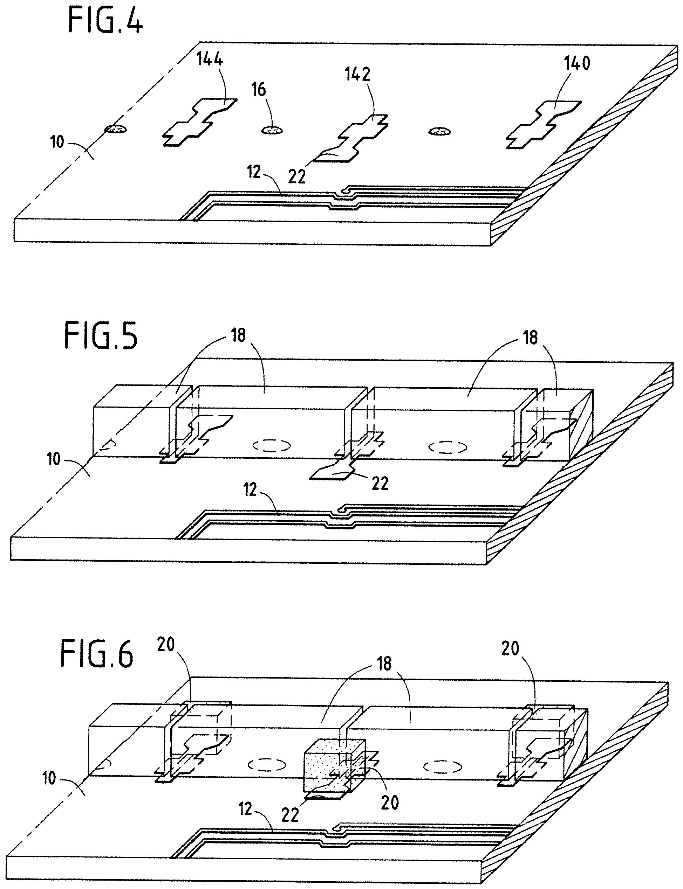

Les figures 4 à 7 illustrent un mode de réalisation de l'invention qui s'applique plus particulièrement au processus de soudage dans un four à refusion.

La figure 4 montre le substrat imprimé avec ses pistes conductrices 12 et ses surfaces conductrices de liaison 140, 142, 144 dessinées sur la surface de la plaque de substrat 10. Comme précédemment, ces surfaces conductrices de liaison en cuivre ou en nickel sont espacées entre elles sensiblement de la longueur d'un barreau conducteur, toutefois, dans ce second mode de réalisation, chacune de ces surfaces peuvent présenter une zone déportée 22 destinée à recevoir un bloc de pâte à souder (voir figure 6). Comme le montre l'exemple de la figure 4, les dimensions et la forme particulière en croix de chaque surface conductrice de liaison est adaptée pour que lors du passage au four, la pâte à souder 20 déposée sur la zone déportée 22 vienne emplir exactement l'espace entre deux barreaux conducteurs adjacents (figure 7).

Comme dans l'exemple précédent, chaque zone de substrat située entre chaque surface conductrice de liaison comportera un ou plusieurs points de colle 16 pour assurer une adhérence suffisante des barreaux conducteurs disposés les uns à la suite des autres sur le substrat lors du processus de soudage ultérieur.

Avec l'invention, comme le passage du courant n'est plus effectué par la piste de puissance (et donc ne souffre plus d'un éventuel goulot d'étranglement au passage sur cette piste) mais au travers des barreaux conducteurs via les joints de soudure, il devient possible de passer des très forts courants, jusqu'à 500 ampères, voire plus, pour un coût particulièrement faible puisque ni le processus de soudage ni la conception du substrat imprimé ne sont modifiés, le substrat restant un circuit standard avec des pistes de cuivre de 35 µm d'épaisseur, y compris les surfaces de liaison.

Il peut être noté que, si dans les exemples illustrés, le rail de puissance est rectiligne avec des barreaux placés les uns derrières les autres, il est évident que celui-ci peut adopter une configuration tout autre, à la manière d'un jeu de domino, avec un rail ayant tournant à 90° ou croisant un autre rail, la liaison électrique réalisée lors du processus de soudage s'effectuant alors par l'intermédiaire de parties de barreaux reposant sur une surface conductrice de liaison commune. Bien entendu, deux au moins des barreaux composant ce rail comporteront à une extrémité latérale un connecteur (une cosse) intégré pour une liaison externe directe (i.e sans passer par une piste du substrat).

Si dans les exemples illustrés les surfaces de liaison sont indépendantes les unes des autres, il est tout à fait possible de les relier entre elles. Dans ce cas, il sera avantageux de prévoir dans la surface conductrice continue ainsi formée des zones d'épargne pour y déposer les points de colle. Cette configuration assure une conduction supplémentaire du courant toutefois faible et sans commune mesure avec celle transmise au travers des barreaux conducteurs.

L'invention est ainsi particulièrement adaptée à la conception de cartes de circuit imprimé destinés à des composants de très fortes puissances, redresseurs ou dispositifs équivalents.

## Revendications

1. Substrat imprimé destiné à recevoir des composants électroniques et comportant des pistes conductrices (12) imprimées sur ce substrat (10) et plusieurs barreaux conducteurs (18) montés les uns à la suite des autres de sorte à former un rail de puissance, **caractérisé en ce qu'**il comporte en outre une pluralité de surfaces conductrices de liaison (140, 142, 144) régulièrement espacées et reliant électriquement entre eux, lors d'un processus de soudage ultérieur, les barreaux conducteurs pour former ledit rail de puissance, les parties des barreaux conducteurs adjacents ainsi reliés électriquement reposant sur une même surface conductrice de liaison et les dimensions desdites surfaces conductrices de liaison sont adaptées pour que, lors du passage dans un four à refusion, une pâte à souder déposée sur une zone (22) d'une surface conductrice de liaison vienne remplir exactement l'espace entre les deux barreaux conducteurs (18) adjacents reposant sur cette surface conductrice de liaison, ladite zone étant déportée par rapport à l'alignement desdits barreaux conducteurs par un étranglement de la surface conductrice de liaison.

2. Substrat imprimé selon la revendication 1, **caractérisé en ce que** lesdites parties des barreaux conducteurs reliés entre elles lors dudit processus de soudage sont les extrémités latérales ou les bords longitudinaux desdits barreaux conducteurs.

3. Substrat imprimé selon la revendication 1, **caractérisé en ce que** lesdits barreaux conducteurs sont maintenus sur ledit substrat par des points de colle (16).

4. Substrat imprimé selon la revendication 1, **caractérisé en ce que** ledit processus de soudage est celui consistant à souder lesdits composants électroniques sur ledit substrat imprimé.

5. Substrat imprimé selon la revendication 1, **caractérisé en ce que** lesdits barreaux conducteurs (18) sont des barreaux métalliques, de préférence en cuivre ou en aluminium.

6. Substrat imprimé selon la revendication 1, **caractérisé en ce que** lesdits barreaux conducteurs (18) sont recouverts d'une protection en alliage de nickel.

7. Substrat imprimé selon la revendication 1, **caractérisé en ce que** chacun desdits barreaux conducteurs (18) a une section déterminée par le niveau de courant à passer.

8. Substrat imprimé selon la revendication 1, **caractérisé en ce que** lesdites surfaces conductrices de liaison sont des surfaces de cuivre ou de nickel.

9. Substrat imprimé selon la revendication 1, **caractérisé en ce que** lesdites surfaces conductrices de liaison sont reliées entre elles pour former une surface conductrice continue.

10. Substrat imprimé selon la revendication 9, **caractérisé en ce que** ladite surface conductrice continue comporte des zones d'épargne pour y déposer lesdits points de colle.

11. Procédé de réalisation d'un substrat imprimé permettant le passage de très forts courants sur au moins une surface conductrice de ce substrat, le substrat imprimé destiné à recevoir des composants électroniques, comportant des pistes conductrices imprimées sur ce substrat et plusieurs barreaux conducteurs (18) montés les uns à la suite des autres de sorte à former un rail de puissance, le procédé étant **caractérisé par** former ladite surface conductrice de plusieurs surfaces conductrices de liaison régulièrement espacées, relier électriquement entre eux, lors d'un processus de soudage ultérieur, les barreaux conducteurs pour former ledit rail de puissance, des parties de barreaux conducteurs adjacents ainsi reliés électriquement reposant sur une même surface conductrice de liaison et les dimensions desdites surfaces conductrices de liaison sont adaptées pour que, lors du passage dans un four à refusion, une pâte à souder déposée sur une zone (22) d'une surface conductrice de liaison vienne remplir exactement l'espace entre les deux barreaux conducteurs (18) adjacents reposant sur cette surface conductrice de liaison, ladite zone étant déportée par rapport à l'alignement desdits barreaux conducteurs par un étranglement de la surface conductrice de liaison.

12. Procédé de réalisation d'un substrat imprimé selon la revendication 11, **caractérisé en ce que** lesdites surfaces conductrices de liaison sont des surfaces de cuivre ou de nickel.

## Patentansprüche

1. Bedrucktes Substrat, das elektronische Bauteile aufnehmen soll und auf dieses Substrat (10) gedruckte Leiterbahnen (12) und mehrere leitfähige Stäbe (18) umfasst, die nacheinander montiert sind, um eine Leistungsschiene zu bilden, **dadurch gekennzeichnet, dass** es außerdem mehrere leitfähige Verbindungsoberflächen (140, 142, 144) umfasst, die regelmäßig beabstandet sind und bei einem späteren Lötprozess die leitfähigen Stäbe elektrisch miteinander verbinden, um die Leistungsschiene zu bilden, wobei die Abschnitte der so elektrisch verbundenen benachbarten leitfähigen Stäbe auf ein und derselben leitfähigen Verbindungsoberfläche aufliegen, und die Abmessungen der leitfähigen Verbindungsoberflächen ausgelegt sind, damit beim Durchgang in einem Aufschmelzofen eine Lötpaste, die auf einer Zone (22) einer leitfähigen Verbindungsoberfläche angeordnet ist, exakt den Raum zwischen den zwei benachbarten leitfähigen Stäben (18) füllt, die auf dieser leitfähigen Verbindungsoberfläche aufliegen, wobei die Zone in Bezug auf die Ausrichtung der leitfähigen Stäbe durch eine Verengung der leitfähigen Verbindungsoberfläche verlagert wird.

2. Bedrucktes Substrat nach Anspruch 1, **dadurch gekennzeichnet, dass** die Abschnitte der leitfähigen Stäbe, die bei dem Lötprozess miteinander verbunden werden, die seitlichen Enden oder die longitudinalen Ränder der leitfähigen Stäbe sind.

3. Bedrucktes Substrat nach Anspruch 1, **dadurch gekennzeichnet, dass** die leitfähigen Stäbe an dem Substrat durch Klebstoffpunkte (16) gehalten werden.

4. Bedrucktes Substrat nach Anspruch 1, **dadurch gekennzeichnet, dass** der Lötprozess jener ist, der aus dem Löten der elektronischen Bauteile an das bedruckte Substrat besteht.

5. Bedrucktes Substrat nach Anspruch 1, **dadurch gekennzeichnet, dass** die leitfähigen Stäbe (18) metallische Stäbe, vorzugsweise aus Kupfer oder Aluminium, sind.

6. Bedrucktes Substrat nach Anspruch 1, **dadurch gekennzeichnet, dass** die leitfähigen Stäbe (18) mit einem Schutz aus einer Nickellegierung bedeckt sind.

7. Bedrucktes Substrat nach Anspruch 1, **dadurch gekennzeichnet, dass** jeder der leitfähigen Stäbe (18) einen durch den Pegel eines zu leitenden Stroms bestimmten Querschnitt aufweist.

8. Bedrucktes Substrat nach Anspruch 1, **dadurch gekennzeichnet, dass** die leitfähigen Verbindungsoberflächen Oberflächen aus Kupfer oder Nickel sind.

9. Bedrucktes Substrat nach Anspruch 1, **dadurch gekennzeichnet, dass** die leitfähigen Verbindungsoberflächen miteinander verbunden sind, um eine kontinuierliche leitfähige Oberfläche zu bilden.

10. Bedrucktes Substrat nach Anspruch 9, **dadurch gekennzeichnet, dass** die kontinuierliche leitfähige Oberfläche Lötstoppzonen umfasst, um dort die Klebstoffpunkte anzuordnen.

11. Verfahren zur Herstellung eines bedruckten Substrats, das den Durchgang von sehr starken Strömen an mindestens einer leitfähigen Oberfläche dieses Substrats ermöglicht, wobei das bedruckte Substrat elektronische Bauteile aufnehmen soll, das auf dieses Substrat gedruckte Leiterbahnen und mehrere leitfähige Stäbe (18) umfasst, die nacheinander montiert sind, um eine Leistungsschiene zu bilden, wobei das Verfahren **gekennzeichnet ist durch** das Ausbilden der leitfähigen Oberfläche aus mehreren leitfähigen Verbindungsoberflächen, die regelmäßig beabstandet sind, das elektrische Verbinden bei einem späteren Lötprozess der leitfähigen Stäbe miteinander, um die Leistungsschiene zu bilden, wobei Abschnitte von so elektrisch verbundenen benachbarten leitfähigen Stäben auf einer gleichen leitfähigen Verbindungsoberfläche aufliegen, und die Abmessungen der leitfähigen Verbindungsoberflächen ausgelegt sind, damit beim Durchgang in einem Aufschmelzofen eine Lötpaste, die auf eine Zone (22) einer leitfähigen Verbindungsoberfläche abgeschieden ist, exakt den Raum zwischen den zwei benachbarten leitfähigen Stäben (18) füllt, die auf dieser leitfähigen Verbindungsoberfläche aufliegen, wobei die Zone in Bezug auf die Ausrichtung der leitfähigen Stäbe **durch** eine Verengung der leitfähigen Verbindungsoberfläche verlagert wird.

12. Verfahren zur Herstellung eines bedruckten Substrats nach Anspruch 11, **dadurch gekennzeichnet, dass** die leitfähigen Verbindungsoberflächen Oberflächen aus Kupfer oder Nickel sind.

## Claims

1. Printed substrate intended to receive electronic components and including conductive tracks (12) printed on this substrate (10) and a plurality of conductive bars (18) that are mounted one after another so as to form a power rail, **characterized in that** it furthermore includes a plurality of conductive connecting areas (140, 142, 144) that are regularly spaced and electrically connect, during a subsequent soldering process, the conductive bars together so as to form said power rail, the portions of the adjacent conductive bars thus electrically connected and resting on a given conductive connecting area and the dimensions of said conductive connecting areas being adapted so that, during passage through a reflow oven, a solder deposited on a zone (22) of a conductive connecting area exactly fills the space between the two adjacent conductive bars (18) resting on this conductive connecting area, said zone being separated from the alignment of said conductive bars by a constriction in the conductive connecting area.

2. Printed substrate according to Claim 1, **characterized in that** those portions of the conductive bars which are connected together during said soldering process are the lateral ends or the longitudinal edges of said conductive bars.

3. Printed substrate according to Claim 1, **characterized in that** said conductive bars are held on said substrate by spots of adhesive (16).

4. Printed substrate according to Claim 1, **characterized in that** said soldering process is that consisting in soldering said electronic components to said printed substrate.

5. Printed substrate according to Claim 1, **characterized in that** said conductive bars (18) are metal bars that are preferably made of copper or aluminium.

6. Printed substrate according to Claim 1, **characterized in that** said conductive bars (18) are covered with a protective coating made of a nickel alloy.

7. Printed substrate according to Claim 1, **characterized in that** each of said conductive bars (18) has a cross section determined by the current level to be passed.

8. Printed substrate according to Claim 1, **characterized in that** said conductive connecting areas are areas of copper or nickel.

9. Printed substrate according to Claim 1, **characterized in that** said conductive connecting areas are connected together to form a continuous conductive area.

10. Printed substrate according to Claim 9, **characterized in that** said continuous conductive area includes zones set aside for depositing thereon said spots of adhesive.

11. Process for producing a printed substrate allowing very high currents to be passed through at least one conductive area of this substrate, the printed substrate, which is intended to receive electronic components, including conductive tracks printed on this substrate and a plurality of conductive bars (18) that are mounted one after another so as to form a power rail, the process being **characterized in that** said conductive area is formed from a plurality of regularly spaced conductive connecting areas, the conductive bars are electrically connected together, during a subsequent soldering process, to form said power rail, and the portions of adjacent conductive bars thus electrically connected and resting on a given conductive connecting area and the dimensions of said conductive connecting areas are adapted so that, during passage through a reflow oven, a solder deposited on a zone (22) of a conductive connecting area exactly fills the space between the two adjacent conductive bars (18) resting on this conductive connecting area, said zone being separated from the alignment of said conductive bars by a constriction in the conductive connecting area.

12. Process for producing a printed substrate according to Claim 11, **characterized in that** said conductive connecting areas are areas of copper or nickel.
